# EUROPÄISCHE PATENTSCHRIFT

(11) **EP 3 190 617 B1**
(45) Veröffentlichungstag und Bekanntmachung des Hinweises auf die Patenterteilung: **24.03.2021**
(21) Anmeldenummer: 16203996.0
(22) Anmeldetag: 14.12.2016
(51) Int. Cl.: H01L 25/075, H01L 33/58, F21V 5/00, G02B 26/00, F21V 14/00, F21S 8/04

(54) **LICHTEMITTIERENDE BAUGRUPPE UND VERFAHREN ZUM HERSTELLEN EINER LICHTEMITTIERENDEN BAUGRUPPE**
LIGHT EMITTING DEVICE AND METHOD OF FABRICATING A LIGHT EMITTING DEVICE
DISPOSITIF ÉLECTROLUMINESCENT ET PROCÉDÉ DE FABRICATION D'UN DISPOSITIF ÉLECTROLUMINESCENT

(30) Priorität: 08.01.2016 DE 102016200157
(43) Veröffentlichungstag der Anmeldung: 12.07.2017
(73) Patentinhaber: SITECO GmbH, 83301 Traunreut (DE)
(72) Erfinder: Wirth, Ralph, 93138 Lappersdorf (DE)
(74) Vertreter: Schmidt, Steffen

(56) Entgegenhaltungen:
- EP-A2- 2 529 975
- US-A1- 2012 026 161

## Beschreibung

Die Erfindung betrifft eine lichtemittierende Baugruppe und ein Verfahren zum Herstellen einer lichtemittierenden Baugruppe.

Die Lichtindustrie wandelt sich weg von traditionellen analogen Leuchtmitteln, hin zu vernetzter Beleuchtung mit LEDs als digital steuerbaren Lichtquellen. Heutzutage sind moderne LED Leuchtmittel effizienter und kostengünstiger als traditionelle Leuchtmittel, wie beispielsweise Glühlampen. In den letzten Jahren wurde neben der Effizienz der Lichtleuchtmittel auch die Lichtqualität verbessert. Dies schließt beispielsweise Weiterentwicklungen im Hinblick auf halbleiterbasierten Lichtquellen mit hoher Farbwiedergabe, der Möglichkeit der Personalisierung von Licht, z.B. Lichtfarbe oder Farbtemperatur, sowie die biologische Wirkung von Licht ein.

In jüngster Zeit nimmt die Digitalisierung des Lichts zu. Diese bedeutet die Vernetzung von Lichtquellen mit Gebäude- und/oder Stadt-Netzwerken, bis hin zu Internet-Service-Angeboten. Die Verknüpfung und Übertragung von Daten innerhalb und außerhalb des Beleuchtungssystems ermöglicht schon jetzt eine situationsbezogene, flexible Lichtsteuerung durch die Verknüpfung von Personen- und Umgebungsdaten. Dabei kann ein Informationsfluss von außerhalb des Beleuchtungssystems, beispielsweise aus persönlichen Clouds der Benutzer und/oder Wetterdiensten genutzt werden, um die Beleuchtung den Bedürfnissen der Nutzer anzupassen und/oder aktiv Informationen durch entsprechende Lichtszenarien an die Nutzer zurückzugeben. Derartige Anwendungen erfordern flexible lichtemittierende Baugruppen, die dynamisch auf Steuersignale reagieren können.

Die Beleuchtung kann grundsätzlich in mindestens drei ihrer Eigenschaften variiert werden. Eine erste Eigenschaft ist die Lichtintensität. Seit dem Beginn der Einführung der LED-Technologie wird die unkomplizierte Dimmbarkeit von LEDs genutzt. Darüber hinaus ermöglicht die einfache Modulierbarkeit von Licht eine Datenübertragung und so beispielsweise die Positionsbestimmung von Mobiltelefonen. Eine zweite Eigenschaft ist das Lichtspektrum. Durch mehrkanalige LED-Systeme lässt sich das Spektrum des Lichts in weiten Bereichen frei den individuellen Bedürfnissen des Nutzers anpassen. Eine dritte Eigenschaft ist die Lichtrichtung, insbesondere die Ausstrahlrichtung oder Fernfeldverteilung. Diese dritte Eigenschaft des Lichts wird heutzutage häufig als starre, durch die Leuchtenkonstruktion einmal vorgegebene Größe gesehen. Mit der Digitalisierung und Dynamisierung von Licht ergeben sich aber insbesondere hier neue weitreichende Möglichkeiten von flexibel anpassbaren Lichtverteilungen über dynamische Lichtszenarien bis hin zur visuellen Informationsübertagung durch das Licht. Solche im Fernfeld dynamischen Systeme, die gleichzeitig auch die Anforderungen an Beleuchtungssysteme in der Allgemeinbeleuchtung erfüllen, sind heute nicht bekannt.

Heutzutage findet man Beleuchtungssysteme, die die dynamische Veränderbarkeit von Fernfeldverteilungen ermöglichen, beispielsweise in der Bühnenbeleuchtung. In diesem technischen Gebiet sind insbesondere sogenannte "Moving Heads" bekannt, welche im wesentlichen motorisierte Scheinwerfer sind, die computergesteuert verschiedene Ausstrahlrichtungen anfahren können. Dies ist jedoch mit der Bewegung erheblicher Massen verbunden. Für die räumlich flexible Allgemeinbeleuchtung sind diese Systeme jedoch ungeeignet, da sie eine vergleichsweise geringe Lebensdauer haben, bei deren Befähigung eine hohe Geräuschentwicklung entsteht, sie diverse für die Allgemeinbeleuchtung wichtige Sicherheitsaspekte nicht erfüllen und/oder die Möglichkeit fehlt, komplexe Beleuchtungsszenarien zu erzeugen, beispielsweise eine Hintergrundbeleuchtung mit sich bewegenden Akzenten.

Ansonsten ist es bekannt, für sich verändernde Beleuchtungsszenen und ggf. zur visuellen Übertragung von Informationen Datenprojektoren zu verwenden. Auf perfekte Abbildungsleistung optimiert, erfüllen diese Systeme ebenfalls nicht die Anforderung an eine Lösung für die Allgemeinbeleuchtung, da zum Einen die Effizienz dieser Systeme um etwa eine Größenordnung zu gering ist und da zum Anderen zwar die Hintergrundbeleuchtung realisiert werden kann, eine gleichzeitige flexible Akzentbeleuchtung aber nicht möglich ist. Hierzu wird in einem engen Raumwinkel ein um mehrere Größenordnungen gegenüber der Hintergrundbeleuchtung erhöhter Lichtstrom benötigt, beispielsweise werden für die Hintergrundbeleuchtung 100 Lux bis 500 Lux benötigt und für die Akzentbeleuchtung 5000 Lux bis 80000 Lux. Dies kann mit konventionellen Projektionssystemen nicht effizient geleistet werden, da die Abbildung hier auf dem Durchlassen der hellen Bildbereiche und dem puren Blocken der dunklen Bereiche basiert.

Es besteht somit erhöhter Handlungsbedarf, räumlich flexible Beleuchtungsmodule zu entwickeln, die den Anforderungen der Allgemeinbeleuchtung Rechnung tragen.

Auf dem Messestand #1922 der Messe LIGHTFAIR International (LFI) vom 5. bis 7. Mai 2015, in New York, wurde ein Downlight Modul mit der Bezeichnung "OmniPoint" von OSRAM, vorgestellt und erhielt die Auszeichnung für das innovativste Produkt des Jahres. Wie die Ehrung zeigt, handelt es sich dabei um die allererste Realisierung einer Leuchte mit variablem Fernfeld für die Allgemeinbeleuchtung. Diese lichtemittierende Baugruppe weist 61 starr installierte Hochleistungs-LEDs mit jeweiliger Optik auf, welche separat via Tablet-Computer und zugehöriger App angesteuert werden können. Damit können flexibel verschiedene Beleuchtungsszenarien realisiert werden. Die lichtemittierende Baugruppe OmniPoint, ermöglicht ca. 400 Lux auf einem Zielfeld von 0,25 m² in 2 Meter Abstand. Die Abstrahlwinkel sind durch die Anstellwinkel der LEDs in der mechanischen Konstruktion fest vorgegeben. Bei dynamischer Ansteuerung sind keine fließenden Übergänge der Abstrahlwinkel möglich. Jede LED benötigt einen separaten LED-Treiber. Der maximale Lichtfluss beträgt ca. 3000 Lumen. Die Außenmaße des Baugruppengehäuses sind ca. 40 cm x 60 cm x 30 cm.

Eine Aufgabe der Erfindung ist es, eine lichtemittierende Baugruppe bereitzustellen, die für die Allgemeinbeleuchtung verwendbar ist und ein variables Fernfeld aufweist, mittels der in einem besonders kleinen Raumwinkelbereich Licht mit einem besonders hohen Lichtstrom variabel bereitstellbar ist, deren Abstrahlwinkel flexibel einstellbar sind, wobei bei einem dynamischen verstellen fließende Übergänge möglich sin sollen, die mit einer einzigen Treiberschaltung ansteuerbar ist, die einen maximalen Lichtfluss von 10.000 Lumen ermöglicht und/oder die in einer standardisierte Montageöffnung für ein Downlight Lichtmodul einsetzbar ist.

US 2012/026161 A1 offenbart eine stereoskopische Anzeige mit einer lichtemittierenden Baugruppe gemäß dem Oberbegriff des Anspruchs 1. Ferner offenbart die EP 2 529 775 A2 ein System, eine Steuereinheit und ein Verfahren zum Steuern einer Lichtverteilung. Eine Lichtquelle wirkt mit Elektrowetting-Linsen zusammen, um die Lichtverteilung zu ändern.

Eine Aufgabe der Erfindung ist es, ein Verfahren zum Betreiben einer lichtemittierenden Baugruppe bereitzustellen, so dass diese für die Allgemeinbeleuchtung verwendbar ist und ein variables Fernfeld aufweist, so dass in einem besonders kleinen Raumwinkelbereich Licht mit einem besonders hohen Lichtstrom variabel bereitstellbar ist, so dass Abstrahlwinkel der lichtemittierenden Baugruppe flexibel einstellbar sind, wobei bei einem dynamischen Verstellen fließende Übergänge möglich sind, und/oder so dass die lichtemittierende Baugruppe mit einer einzigen Treiberschaltung ansteuerbar ist.

Eine Aufgabe wird gemäß einem Aspekt der Erfindung gelöst durch eine lichtemittierende Baugruppe gemäß Anspruch 1 sowie durch ein Verfahren gemäß Anspruch 15.

Die ansteuerbaren Lichtumlenkelemente ermöglichen, dass die lichtemittierende Baugruppe Licht emittiert, dessen Fernfeldverteilung flexibel steuerbar ist. Die Linsen, die das von den LEDs emittierte Licht kollimieren bzw. fokussieren, ermöglichen durch die Parallelrichtung bzw. Konzentration von mehreren Strahlbündeln hohe Beleuchtungsstärken. Außerdem ermöglichen die Linsen, das gemäß einer Lambert'schen Strahlverteilung von den LEDs emittierte Licht derart zu parallelisieren bzw. zu bündeln, dass es nachfolgend gezielt geformt und abgelenkt werden kann. Anders als bei Projektoren kann mittels der LEDs erzeugtes Licht vollständig durch die optischen Elemente abgebildet werden, wodurch eine besonders hohe Effizienz möglich ist. Eine funktionalisierte Optik, die die optischen Elemente aufweist, kann beispielsweise aufgrund diffraktiver optischer Elemente und refraktiver optischer Elemente als diffraktive-refraktive Hybrid-Optik ausgebildet sein und ermöglicht, einen im Leuchtenbau angemessenen Formfaktor zu erfüllen, und insbesondere die Teilstrahlen der LEDs in den Halbraum abzubilden. Die optischen Elemente können beispielsweise die Funktion einer nicht abbildenden Weitwinkel-Optik haben, die die Variationen der Lichtumlenkelemente verstärkt.

Erfindungsgemäß sind die Lichtumlenkelemente optische Linsen mit elektrisch verstellbarem Fokuspunkt und/oder mit elektrisch verstellbarer Brennweite. Dies ermöglicht eine dynamische Veränderung der Lichtverteilung im Fernfeld ohne oder mit zumindest vernachlässigbarer Geräuschentwicklung. Außerdem werden keine motorisierten und/oder beweglichen Bauteile benötigt.

Gemäß einer Weiterbildung sind die Lichtumlenkelemente Fluidikzellen. Fluidikzellen ermöglichen eine sehr schnelle und sehr präzise Umlenkung des Lichts abhängig von einer elektrischen Ansteuerung der Fluidikzellen. Die Fluidikzellen weisen in der Regel zwei verschiedene Flüssigkeiten auf, die sich nicht mischen und die eine Grenzfläche zueinander bilden. Die Grenzfläche kann mittels Elektrischer Felder verändert werden. Beispielsweise können mittels der Grenzfläche dreidimensionale Strukturen, insbesondere optische Linsen oder prismenartige Gebilde, erzeugt werden, die das Licht umlenken.

Gemäß einer Weiterbildung sind die Lichtumlenkelemente Fluidlinsen. Insbesondere können die Fluidikzellen Fluidlinsen mit elektrisch verstellbarem Fokuspunkt und/oder mit elektrisch verstellbarer Brennweite sein. Dies ermöglicht eine sehr schnelle und/oder sehr präzise Verstellung des Fokuspunkt bzw. der Brennweite. Außerdem können in diesem Fall die Lichtumlenkelemente und damit auch die lichtemittierende Baugruppe sehr kompakt ausgebildet werden.

Gemäß einer Weiterbildung sind bei den Fluidlinsen der Fokuspunkt und/oder die Brennweite mittels Elektrobenetzung verstellbar. Dies ermöglicht auf einfache und/oder präzise Weise den Fokuspunkt bzw. die Brennweite zu verstellen.

Gemäß einer Weiterbildung sind die Lichtumlenkelemente jeweils einer der Linsen zugeordnet und lenken das Licht, das von der entsprechenden Linse kollimiert und/oder fokussiert wird, um. Beispielsweise ist jedem Lichtumlenkelement genau eine Linse zugeordnet. Die Vorkollimation bzw. Vorfokussierung des von den LEDs erzeugten Lichts mittels der Linsen trägt dazu bei, dass die Lichtumlenkelemente das kollimierte bzw. fokussierte Licht besonders präzise umlenken können.

Gemäß einer Weiterbildung kollimieren die Linsen das mittels der LEDs erzeugte Licht und Strahlengänge des mittels verschiedener Linsen kollimierten Lichts sind parallel zueinander. Dies trägt dazu bei, dass die LEDs und/oder die Linsen besonders einfach ausgebildet und angeordnet werden können.

Gemäß einer Weiterbildung sind jeder Linse zwei oder mehr der LEDs zugeordnet und die Linsen kollimieren und/oder fokussieren das Licht der entsprechenden LEDs. Beispielsweise können die LEDs, die derselben Linse zugeordnet sind, Licht unterschiedlicher Farbe emittieren. Beispielsweise können die LEDs, die derselben Linse zugeordnet sind, eine rotes Licht emittierende LED, eine grünes Licht emittierende LED und eine blaues Licht emittierende LED aufweisen.

Gemäß einer Weiterbildung sind die Linsen TIR-Linsen. Die TIR-Linsen tragen dazu bei, dass die lichtemittierende Baugruppe besonders effizient ist.

Gemäß einer Weiterbildung sind die optischen Elemente so ausgebildet und angeordnet, dass paralleles Licht, das auf die optischen Elemente trifft, von unterschiedlichen der optischen Elemente in entsprechend unterschiedliche Richtungen umgelenkt wird. Dadurch kann beispielsweise erreicht werden, dass im Fernfeld an verschiedenen Raumpositionen Lichtakzente erzeugt werden. Alternativ dazu kann dadurch beispielsweise erreicht werden, dass Licht, das durch unterschiedliche der optische Elemente tritt, im Fernfeld auf dieselbe Raumposition gelenkt wird, so dass in diesem Raumbereich das Licht konzentriert wird und ein besonders starker Lichtakzent erzeugt wird.

Gemäß einer Weiterbildung sind eines, zwei oder mehr der optischen Elemente so ausgebildet, dass Licht, das in einer vorgegebenen Richtung auf einen Teilbereich des entsprechenden optischen Elements gelenkt wird, in eine andere Richtung umgelenkt wird, als Licht das in der vorgegebenen Richtung auf einen anderen Teilbereich des entsprechenden optischen Elements gelenkt wird. Dies kann ermöglichen, dass eine relativ geringe Ablenkung des Lichts mittels der Lichtumlenkelemente, und zwar von dem einen Teilbereich auf den anderen Teilbereich des entsprechenden optischen Elements, zu einer durch den entsprechenden Teilbereich verstärkten Ablenkung und somit zu einer großen Richtungsänderung des abgestrahlten Lichts führt. Ferner kann mittels der Teilbereiche ein Umschalten optischer Funktionen erreicht werden. Beispielsweise können die unterschiedlichen Teilbereiche unterschiedliche Strahlformungen bewirken, beispielsweise einmal einen ovalen Strahlquerschnitt und einmal einen kreisrunden Strahlquerschnitt.

Gemäß einer Weiterbildung ist den optischen Elementen jeweils eines der Lichtumlenkelemente zugeordnet und die optischen Elemente lenken das von dem entsprechenden Umlenkelement umgelenkte Licht um.

Gemäß einer Weiterbildung weisen die optischen Elemente diffraktive Elemente und/oder refraktive Elemente auf.

Gemäß einer Weiterbildung sind die LEDs jeweils in LED-Gehäusen angeordnet, die auf dem Träger angeordnet sind.

Gemäß einer Weiterbildung sind alle LEDs, die derselben Linse zugeordnet sind, in demselben LED-Gehäuse angeordnet.

Eine Aufgabe wird gemäß einem Aspekt der Erfindung gelöst durch ein Verfahren zum Betreiben der lichtemittierenden Baugruppe, bei dem die LEDs so angesteuert werden, dass sie das Licht emittieren, welches von den den LEDs zugeordneten Linsen in den Strahlengängen der LEDs kollimiert und/oder fokussiert wird und auf mehrere Lichtumlenkelemente gerichtet wird, und die Lichtumlenkelemente, die jeweils das auf sie treffende Licht umlenken, so angesteuert werden, dass die jeweilige Richtung, in die das Licht von ihnen umgelenkt wird, abhängig von der Ansteuerung veränderbar ist, und dass das Licht abhängig von der Ansteuerung auf verschiedene Teilbereiche mehrerer optischer Elemente, die das mittels der Lichtumlenkelemente umgelenkte Licht umlenken, gerichtet wird.

Die im Vorhergehenden im Zusammenhang mit der lichtemittierenden Baugruppe erläuterten Vorteile und/oder Ausgestaltungen können ohne weiteres auf das Verfahren zum Betreiben der lichtemittierenden Baugruppe übertragen werden.

Ausführungsbeispiele der Erfindung sind in den Figuren dargestellt und werden im Folgenden näher erläutert.

Es zeigen:
- Figur 1: eine schematische Seitenansicht eines Ausführungsbeispiels einer lichtemittierenden Baugruppe;
- Figur 2: eine schematische Seitenansicht eines Teils eines Ausführungsbeispiels einer lichtemittierenden Baugruppe;
- Figur 3: eine schematische Seitenansicht eines Teils eines Ausführungsbeispiels einer lichtemittierenden Baugruppe;
- Figur 4: eine schematische Seitenansicht eines Teils eines Ausführungsbeispiels einer lichtemittierenden Baugruppe;
- Figur 5: eine schematische Seitenansicht eines Teils eines Ausführungsbeispiels einer lichtemittierenden Baugruppe;
- Figur 6: eine schematische Seitenansicht eines Teils eines Ausführungsbeispiels einer lichtemittierenden Baugruppe;
- Figur 7: eine schematische Seitenansicht eines Teils eines Ausführungsbeispiels einer lichtemittierenden Baugruppe;
- Figur 8: eine schematische Seitenansicht eines Teils eines Ausführungsbeispiels einer lichtemittierenden Baugruppe.

In der folgenden ausführlichen Beschreibung wird auf die beigefügten Zeichnungen Bezug genommen, die Teil dieser Beschreibung bilden und in denen zur Veranschaulichung spezifische Ausführungsbeispiele gezeigt sind, in denen die Erfindung ausgeübt werden kann. Da Komponenten von Ausführungsbeispielen in einer Anzahl verschiedener Orientierungen positioniert werden können, dient die Richtungsterminologie zur Veranschaulichung und ist auf keinerlei Weise einschränkend. Es versteht sich, dass andere Ausführungsbeispiele benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen Ausführungsbeispiele miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert. In den Figuren sind identische oder ähnliche Elemente mit identischen Bezugszeichen versehen, soweit dies zweckmäßig ist.

Eine optoelektronische Baugruppe kann ein, zwei oder mehr optoelektronische Bauelemente aufweisen. Optional kann eine optoelektronische Baugruppe auch ein, zwei oder mehr elektronische Bauelemente aufweisen. Ein elektronisches Bauelement kann beispielsweise ein aktives und/oder ein passives Bauelement aufweisen. Ein aktives elektronisches Bauelement kann beispielsweise eine Rechen-, Steuer- und/oder Regeleinheit und/oder einen Transistor aufweisen. Ein passives elektronisches Bauelement kann beispielsweise einen Kondensator, einen Widerstand, eine Diode oder eine Spule aufweisen.

Ein optoelektronisches Bauelement kann ein elektromagnetische Strahlung emittierendes Bauelement oder ein elektromagnetische Strahlung absorbierendes Bauelement sein. Ein elektromagnetische Strahlung absorbierendes Bauelement kann beispielsweise eine Solarzelle sein. Ein elektromagnetische Strahlung emittierendes Bauelement kann in verschiedenen Ausführungsbeispielen ein elektromagnetische Strahlung emittierendes Halbleiter-Bauelement sein und/oder als eine elektromagnetische Strahlung emittierende Diode, als eine organische elektromagnetische Strahlung emittierende Diode, als ein elektromagnetische Strahlung emittierender Transistor oder als ein organischer elektromagnetische Strahlung emittierender Transistor ausgebildet sein. Die Strahlung kann beispielsweise Licht im sichtbaren Bereich, UV-Licht und/oder Infrarot-Licht sein. In diesem Zusammenhang kann das elektromagnetische Strahlung emittierende Bauelement beispielsweise als Licht emittierende Diode (light emitting diode, LED) als organische Licht emittierende Diode (organic light emitting diode, OLED), als Licht emittierender Transistor oder als organischer Licht emittierender Transistor ausgebildet sein. Das Licht emittierende Bauelement kann in verschiedenen Ausführungsbeispielen Teil einer integrierten Schaltung sein. Weiterhin kann eine Mehrzahl von Licht emittierenden Bauelementen vorgesehen sein, beispielsweise untergebracht in einem gemeinsamen Gehäuse.

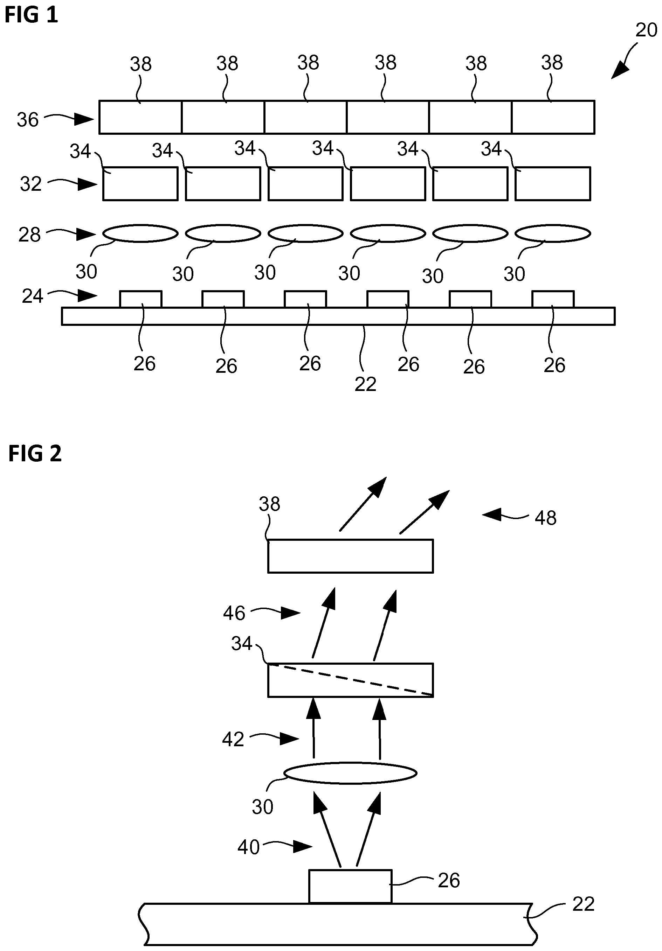

**Fig. 1** zeigt eine schematische Seitenansicht eines Ausführungsbeispiels einer lichtemittierenden Baugruppe 20. Die lichtemittierende Baugruppe 20 weist einen Träger 22 auf. Der Träger 22 kann beispielsweise Metall und/oder Kunststoff aufweisen. Der Träger 22 kann beispielsweise eine Leiterplatte, beispielsweise eine Metallkernplatine oder eine FR1-, FR2-, FR3- , FR4-, FR5-, CEM1-, CEM2-, CEM3-, CEM4- oder CEM5-Leiterplatte sein, beispielsweise eine durchkontaktierte FR-4-Leiterplatte.

Die lichtemittierende Baugruppe 20 weist eine LED-Anordnung 24 auf. Die LED Anordnung 24 weist mehrere LEDs 26 auf. Die LEDs 26 sind auf dem Träger 22 angeordnet. Die LEDs 26 können beispielsweise über den Träger 22 elektrisch kontaktiert sein. Beispielsweise können elektrische Kontakte der LEDs 26 mit Leiterbahnen des Trägers 22 elektrisch verbunden sein, beispielsweise mittels Lötens und/oder nicht dargestellter Drähte, beispielsweise mittels Bonddrähten. Die lichtemittierende Baugruppe 20 kann weit mehr als die dargestellten LEDs 26 aufweisen. Beispielsweise kann die lichtemittierende Baugruppe 20 zwischen 50 und 150, beispielsweise zwischen 80 und 120, beispielsweise 100 LEDs 26 aufweisen. Die LEDs 26 können im Betrieb beispielsweise grünes, rotes, blaues und/oder weißes Licht emittieren. Die LEDs 26 emittieren das Licht jeweils beispielsweise gemäß einer Lambert'schen Strahlverteilung. Beispielsweise hat das von jeder der LEDs 26 emittierte Licht einen Öffnungswinkel von 120°. Die LEDs 26 können jeweils eine lichtemittierende Fläche von beispielsweise 0,1 mm² bis 1 mm², beispielsweise von 0,25 mm² bis 0,5 mm² aufweisen. Ein lateraler Abstand zwischen den LEDs 26 kann in einem Bereich liegen beispielsweise von 1 mm bis 100 mm, beispielsweise von 5 mm bis 50 mm, beispielsweise bei ungefähr 10 mm.

Die LEDs 26 sind vorzugsweise unabhängig voneinander ansteuerbar. Beispielsweise können die LEDs 26 unabhängig voneinander an- oder ausgeschaltet werden und/oder die Helligkeit des von den einzelnen LED 26 emittierten Lichts kann unabhängig voneinander eingestellt werden. Zum Betreiben der LED-Anordnung 24, insbesondere der LEDs 26, wird eine nicht dargestellte Treiberanordnung verwendet. Falls alle LEDs 26 unabhängig voneinander betrieben werden können, so weist die Treiberanordnung eine gleich große Anzahl von Treiberkanälen auf, wie LEDs 26 vorhanden sind. Eine derartige Treiberanordnung kann beispielsweise nach Art eines Aktiv-Matrix-Treibers ausgestaltet sein, wie er beispielsweise im Bereich von Flachbildschirmen verwendet wird. Vorzugsweise ermöglicht die Treiberanordnung die Versorgung jeder einzelnen LED 26 mit Gleichstrom, was vorteilhaft ist, um einen gewünschten Lichtfluss und eine hohe Effizienz zu realisieren.

Die lichtemittierende Baugruppe 20 weist eine Linsenanordnung 28 auf. Die Linsenanordnung 28 weist mehrere Linsen 30 auf. Die Linsen 30 sind insbesondere optische Linsen zum kollimieren und/oder fokussieren von Licht. Die Linsen 30 können in der Linsenanordnung 28 mechanisch miteinander verbunden sein. Die Linsenanordnung 28 und insbesondere die Linsen 30 sind in Strahlrichtung des von den LEDs 26 emittierten Lichts nach den LEDs 26 angeordnet. Jede der Linsen 30 ist mindestens einer der LEDs 26 zugeordnet. Beispielsweise ist jede der Linsen 30 genau einer der LEDs 26 zugeordnet. Die Linsen 30 sind jeweils in den Strahlengängen des Lichts der LEDs 26 angeordnet, denen sie zugeordnet sind. Somit kollimiert oder fokussiert jede der Linsen 30 das Licht der LED 26 der die entsprechende Linse 30 zugeordnet ist. Die Linsen 30 können insbesondere dazu dienen, das von den LEDs 26 relativ breit abgestrahlte Licht, beispielsweise gemäß der lambert'schen Strahlverteilung und beispielsweise mit dem Öffnungswinkel von 120°, in einem zumindest weitgehend kollimierten Strahl mit einem Öffnungswinkel in einem Bereich von beispielsweise 1° bis 20°, beispielsweise von 5° bis 15°, beispielsweise von ungefähr 10° umzuformen. Eine sich in lateraler Richtung erstreckende Breite der Linsen 30 kann jeweils beispielsweise ca. ein zehnfaches, beispielsweise ca. ein fünfzehnfaches, beispielsweise ca. ein zwanzigfaches, der lichtemittierenden Fläche der einzelnen LEDs 26 aufweisen. Die einzelnen Linsen 30 können beispielsweise fest miteinander verbunden sein. Alternativ zu den Linsen 30 kann eine flache Fresnel-Optik angeordnet sein, die das von den LEDs 26 emittierte Licht auf einen Öffnungswinkel in einem Bereich von beispielsweise 1° bis 20°, beispielsweise von 5° bis 15°, beispielsweise von ungefähr 10° fokussiert.

Die lichtemittierende Baugruppe 20 weist ein Lichtumlenkmodul 32 auf. Das Lichtumlenkmodul 32 weist mehrere Lichtumlenkelemente 34 auf. Die Lichtumlenkelemente 34 können in dem Lichtumlenkmodul 32 mechanisch miteinander verbunden sein. Das Lichtumlenkmodul 32 und insbesondere die Lichtumlenkelemente 34 sind in Strahlrichtung des von den LEDs 26 emittierten Lichts hinter der Linsenanordnung 28 und den Linsen 30 angeordnet. Jedem der Lichtumlenkelemente 34 ist mindestens eine der Linsen 30 zugeordnet. Beispielsweise ist jedem Lichtumlenkelement 34 genau eine der Linsen 30 zugeordnet. Die Lichtumlenkelemente 34 sind so angeordnet, dass das Licht, das von den Linsen 30 kollimiert und/oder fokussiert wurde, auf die Lichtumlenkelemente 34 trifft. Die Lichtumlenkelemente 34 sind insbesondere so angeordnet, dass genau das Licht, das von den Linsen 30 kollimiert und/oder fokussiert wurde, auf die Lichtumlenkelemente 32 trifft, die den entsprechenden Linsen 30 zugeordnet sind.

Die Lichtumlenkelemente 34 sind jeweils optische Linsen mit elektrisch verstellbarem Fokuspunkt und/oder mit elektrisch verstellbarer Brennweite und/oder Fluidikzellen. Die Lichtumlenkelemente, insbesondere die Fluidikzellen, sind beispielsweise Fluidlinsen, deren Fokuspunkt und/oder Brennweite mittels Elektrobenetzung verstellbar ist. Die Lichtumlenkelemente 34 können je nach Auslegung den Strahlwinkel oder den Öffnungswinkel des von den Linsen 30 kommenden Lichts verändern. Die Lichtumlenkelemente 34 können beispielsweise mittels einer nicht dargestellten Treiberschaltung angesteuert werden, damit sie ihren Fokuspunkt bzw. ihre Brennweite verstellen. Die Treiberschaltung kann beispielsweise der Treiberanordnung zum Steuern der LEDs 26 entsprechen, in dieser angeordnet sein oder, im Unterschied dazu, eine von der Treiberanordnung unabhängige Schaltung sein.

Fluidikzellen, insbesondere Fluidlinsen, bestehen im Wesentlichen aus einer Kammer, die mindestens ein Kammerfenster aufweist und in der sich zwei Flüssigkeiten befinden, die sich nicht mischen, beispielsweise eine polare Flüssigkeit und eine unpolare Flüssigkeit, beispielsweise eine wässrige Flüssigkeit und eine ölige Flüssigkeit, von beispielsweise näherungsweise gleicher Dichte, aber mit unterschiedlichen Brechungsindizes und elektrischen Eigenschaften. Mittels einer in der Kammer angeordneten ersten Elektrode und einer außerhalb der Kammer angeordneten zweiten Elektrode kann in der Kammer ein elektrisches Feld erzeugt werden, das abhängig von seiner Richtung, Ausrichtung und Stärke eine Form und Lage der Grenzfläche zwischen den beiden Flüssigkeiten verändert, wodurch Einfluss auf die Lichtbrechung an der Grenzfläche genommen werden kann. Beispielsweise kann die erste Elektrode in der Kammer eine Ringelektrode sein und die zweite Elektrode außerhalb der Kammer, beispielsweise direkt an dem Kammerfenster, kann eine transparente Indiumzinnoxid(ITO)-Elektrode sein. Gegebenenfalls kann mit einer elektrischen Spannung beispielsweise bis ca. 60 Volt zwischen der ersten Elektrode und der zweiten Elektrode das elektrische Feld gesteuert werden. Das elektrische Feld verändert über den Effekt der Elektrobenetzung den Kontaktwinkel eines Tropfens der polaren Flüssigkeit innen an dem Kammerfenster. Der halbkugelig anliegende Tropfen wird dadurch an der Innenwand des Kammerfensters breiter und verringert so die Krümmung seiner Oberfläche und damit der brechungswirksamen Phasengrenzfläche, wodurch die von der Grenzfläche geformte Linse ihre Brennweite ändert. Damit kann eine Fokussierung oder ein Zoom realisiert werden. Optional kann mittels mehreren, beispielsweise vier radial angeordneten, Elektroden gezielt ein dosiertes keilartiges Verzerren oder Verschieben des die Grenzfläche bildenden Tropfens erzielt werden. Dadurch können beispielsweise komplexe dreidimensionale Grenzflächen, beispielsweise prismenartige und/oder pyramidenförmige Gebilde, erzeugt werden.

Die lichtemittierende Baugruppe 20 weist eine funktionalisierte Optik 36 auf. Die funktionalisierte Optik 36 weist mehrere optische Elemente 38 auf. Die optischen Elemente 38 sind den Lichtumlenkelementen 34 zugeordnet. Beispielsweise ist jedem Lichtumlenkelement 34 genau ein optisches Element 38 zugeordnet. Die optischen Elemente 38 dienen dazu, das Licht, das von den ihnen zugeordneten Lichtumlenkelementen 34 kommt, zu beeinflussen, beispielsweise umzulenken oder aufzuweiten. Die optischen Elemente 38 sind jeweils diffraktive und/oder refraktive optische Elemente. In anderen Worten können die optischen Elemente 38 jeweils ausschließlich diffraktiv wirken, ausschließlich refraktiv wirken oder diffraktiv wirkende Teilbereiche und refraktiv wirkende Teilbereiche aufweisen. Die optischen Elemente 38 können an sich voneinander unabhängige Elemente sein, die beispielsweise über einen Rahmen aneinander befestigt sind, oder die optischen Elemente 38 können Abschnitte eines einstückigen und/oder monolithischen Körpers, beispielsweise einer einzelnen makroskopisch ebenen Scheibe, sein. Die optischen Elemente 38 bilden das mittels der Lichtumlenkelemente 38 umgelenkte Licht in einen mittels der lichtemittierenden Baugruppe 20 zu beleuchtenden Halbraum ab. Die optischen Elemente 38 dienen beispielsweise jeweils dazu, eine mittels der Lichtumlenkelemente 34 bewirkte Ablenkung des von den Linsen 30 kommenden Lichts zu verstärken, umzukehren oder aufzuheben oder das von den Linsen 30 kommende Licht zu formen, beispielsweise aufzuweiten, zu kollimieren oder zu fokussieren, oder einen Strahlquerschnitt zu verändern, beispielsweise von einem ovalen Strahlquerschnitt hin zu einem kreisförmigen Strahlquerschnitt oder von einem kreisförmigen Strahlquerschnitt hin zu einem ovalen Strahlquerschnitt. Die diffraktive Elemente können beispielsweise zum Erzielen einer gezielten Streuung verwendet werden.

Die diffraktiven Elemente können beispielsweise mikroskopische Strukturen oder Elemente aufweisen, deren maximale Ausdehnungen im Bereich der von den LEDs 26 erzeugten Wellenlänge liegen. Beispielsweise können die Ausdehnungen im Bereich von 200 nm bis 1000 nm liegen. Die diffraktive Elemente können beispielsweise von einer oder mehreren transparenten Platten, beispielsweise Glasplatten oder Kunststoffplatten, an deren Oberfläche oder in denen Prismen, Mikrolinsen und/oder Hügel-Tal-Strukturen ausgebildet sind, gebildet sein.

Die refraktiven Elemente können mesoskopische Gebilde und/oder Strukturen aufweisen, deren maximale Ausdehnungen größer als die Wellenlänge des von den LEDs 26 erzeugten Lichts und kleiner als die maximale Ausdehnung eines der optischen Elemente 38 sein. Die mesoskopischen Gebilde bzw. Strukturen können beispielsweise Prismen oder Linsen aufweisen. Die refraktiven Elemente können beispielsweise von einer oder mehreren transparente Platten, beispielsweise Glasplatten oder Kunststoffplatten, an deren Oberfläche oder in denen die Gebilde bzw. Strukturen ausgebildet sind, gebildet sein.

Optional können die diffraktiven Elemente und die refraktiven Elemente derart miteinander kombiniert sein, dass die diffraktiven Elemente, insbesondere die mikroskopischen Gebilde bzw. Strukturen der diffraktiven Elemente, auf den Oberflächen der refraktiven Elemente, insbesondere der mesoskopischen Gebilde bzw. Strukturen der refraktiven Elemente, ausgebildet sind.

Mit der lichtemittierenden Baugruppe 20 ist ein maximaler Gesamtlichtstrom in einem Bereich beispielsweise von 1000 Lumen bis 20000 Lumen, beispielsweise von 5000 Lumen bis 15000 Lumen, beispielsweise von ungefähr 10000 Lumen möglich. Ferner kann eine korrelierte Farbtemperatur in einem Bereich beispielsweise von 2500 K bis 8500 K, beispielsweise um die in der Beleuchtungstechnik üblichen Farborte von 3000 K, 4000K, 5000, 6000K, und/oder mit einem Farbwiedergabeindex CRI in einem Bereich beispielsweise von 70 bis 90, beispielsweise von 75 bis 85, beispielsweise von ungefähr 80, erzielt werden. Die lichtemittierende Baugruppe 20 kann eine Effizienz in einem Bereich beispielsweise von 100 bis 200 Lumen/Watt, beispielsweise von 120 bis 160 Lumen/Watt, beispielsweise von ungefähr 140 Lumen/Watt, erreichen. Außerdem ist eine Akzentbeleuchtung in einem Abstand von beispielsweise 2 Metern möglich, bei der beispielsweise vier unabhängige und dynamisch verstellbare Akzentbeleuchtungen mit einem Lichtfluss jeweils beispielsweise von 1500 Lumen bis 2500 Lumen, beispielsweise von 1800 Lumen bis 2200 Lumen, beispielsweise von ungefähr 2000 Lumen auf einer Zielfläche von beispielsweise 0,25 m², also im Falle von 2000 Lumen mit ca. 8000 Lux, möglich sind.

Der Träger 22 mit den LEDs 26, das Linsenmodul 28, das Lichtumlenkmodul 32 und die funktionalisierte Optik 36 können in einem gemeinsamen, insbesondere kompakten, Baugruppengehäuse angeordnet sein.

**Fig. 2** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 2 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit Geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer Flüssiglinse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche korrespondiert.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden. Eine von dem Lichtumlenkelement 34 bewirkte Ablenkung des dritten Lichts 46 wird mittels des optischen Elements 38 verstärkt, so dass ein Winkel zwischen Geraden entlang von Strahlengängen des vierten Lichts 48 und Geraden entlang von Strahlengängen des zweiten Lichts 42 größer ist als zwischen den Geraden entlang der Strahlengänge des dritten Lichts 46 und den Geraden entlang der Strahlengänge des zweiten Lichts 42.

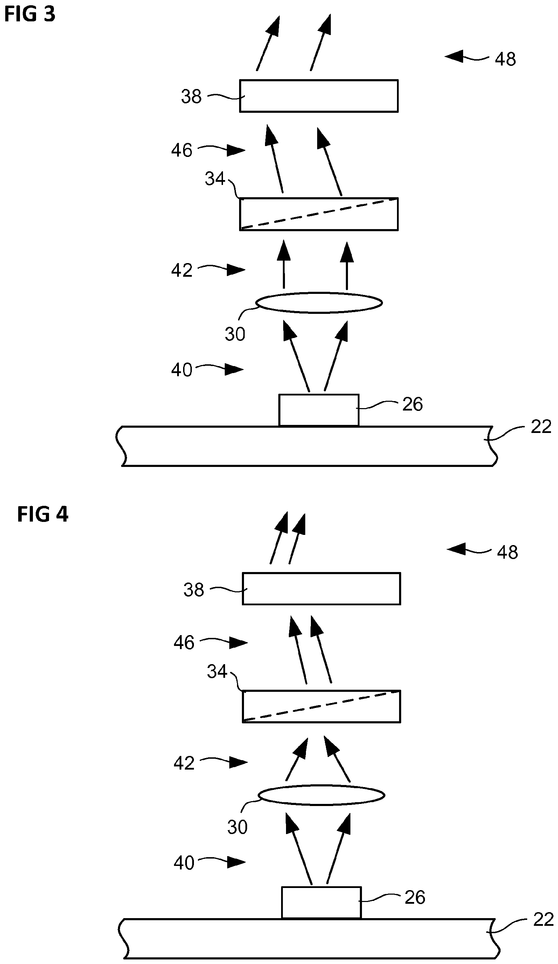

**Fig. 3** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 3 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit Geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer Flüssiglinse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche korrespondiert. Das in Figur 3 dargestellte Lichtumlenkelement 34 kann beispielsweise dasselbe Lichtumlenkelement 34 sein, welches auch in Figur 2 dargestellt ist, wobei es sich aktuell in einem anderen Zustand befindet, beispielsweise weil es anders angesteuert wird. Insbesondere wird das in Figur 3 dargestellte Lichtumlenkelement 34 so angesteuert, dass das dritte Licht 46 in eine andere Richtung abgestrahlt wird als in dem in Figur 2 dargestellten Zustand des Lichtumlenkelements 34.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden. Eine von dem Lichtumlenkelement 34 bewirkte Ablenkung des dritten Lichts 46 wird mittels des optischen Elements 38 verstärkt, so dass ein Winkel zwischen Geraden entlang von Strahlengängen des vierten Lichts 48 und Geraden entlang von Strahlengängen des zweiten Lichts 42 größer ist als zwischen den Geraden entlang der Strahlengänge des dritten Lichts 46 und den Geraden entlang der Strahlengänge des zweiten Lichts 42. Das in Figur 3 gezeigte optische Element 38 kann beispielsweise dem in Figur 2 gezeigten optischen Element 38 entsprechen, so dass dieses das dritte Licht 46 in die gleiche Richtung ablenkt, wie das in Figur 2 gezeigte optische Element 38. Daraus ergibt sich, dass auch das in Figur 3 gezeigte vierte Licht 48 eine andere Richtung hat wie das in Figur 2 gezeigte vierte Licht 48.

**Fig. 4** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 4 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 fokussiert das von der LED 26 kommende Licht.

Das Lichtumlenkelement 34 ist so ausgebildet und angeordnet, dass das von der Linse 30 kommende fokussierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Ein Grad und/oder eine Richtung der Ablenkung des Lichts mittels des Lichtumlenkelements 34 kann abhängig von der elektrischen Ansteuerung des Lichtumlenkelements 34 verändert werden.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden.

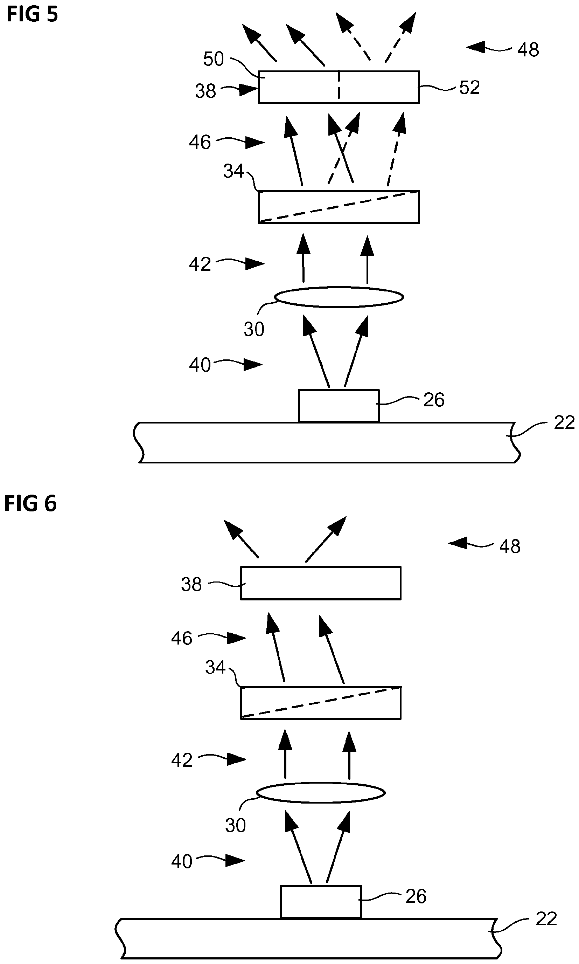

**Fig. 5** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 5 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer Lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit Geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer somit Linse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden. Eine von dem Lichtumlenkelement 34 bewirkte Ablenkung des dritten Lichts 46 wird mittels des optischen Elements 38 verstärkt. Das optische Element 38 weist einen ersten Teilbereich 50 und einen lateral daneben angeordneten Teilbereich 52 auf. Der erste Teilbereich 50 lenkt das auf ihn treffende dritte Licht 46 in eine andere Richtung ab, wie der zweite Teilbereich 52, so dass von dem ersten Teilbereich 50 das vierte Licht 48 in eine andere Richtung abgestrahlt wird als von dem zweiten Teilbereich 52. Mittels des Lichtumlenkelements 34 kann das dritte Licht 46 auf den ersten Teilbereich 50, auf den zweiten Teilbereich 52 oder auf den ersten und zweiten Teilbereich 50, 52 gelenkt werden. Mittels der gestrichelten Pfeile ist ein Fall dargestellt, in dem das Lichtumlenkelement 34 das Licht auf den zweiten Teilbereich 52 lenkt und in dem das optische Element 38 in dem zweiten Teilbereich 52 eine Aufweitung, also eine Vergrößerung des Öffnungswinkels, des einfallenden Lichts bewirkt.

**Fig. 6** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 6 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer Lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit Geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer Flüssiglinse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche.

Das optische Element 38 ist so ausgebildet und angeordnet, dass das von dem Lichtumlenkelement 34 kommende Licht auf das optische Element 38 trifft und von diesem abgelenkt, insbesondere aufgeweitet, wird. In anderen Worten wird ein Öffnungswinkel des dritten Lichts 46 mittels des optischen Elements 38 vergrößert. Das von dem optischen Element 38 aufgeweitete Licht kann auch als viertes Licht 48 bezeichnet werden.

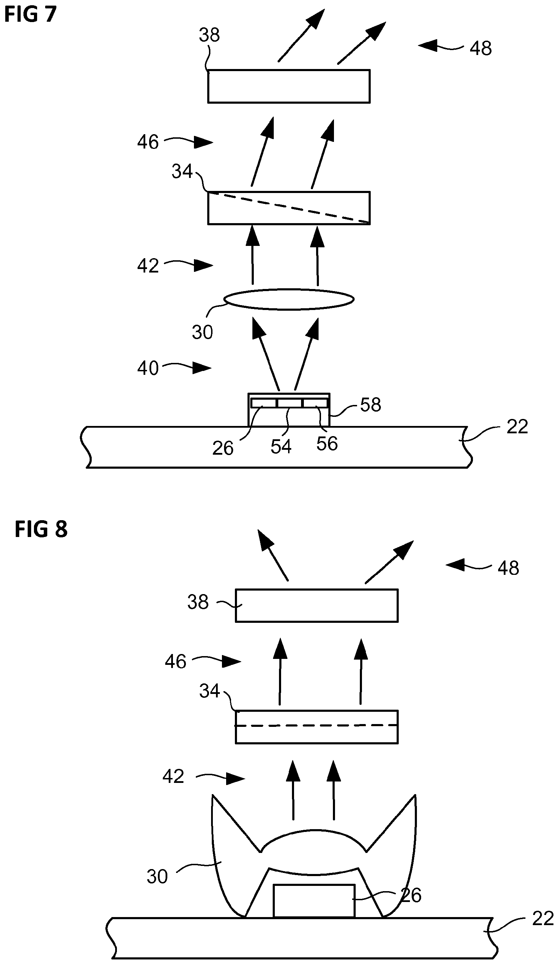

**Fig. 7** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 7 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Zusätzlich zu der LED 26, die in diesem Zusammenhang als erste LED 26 bezeichnet wird, sind eine zweite LED 54 und eine dritte LED 56 angeordnet. Die LEDs 26, 54, 56 sind in einem gemeinsamen LED-Gehäuse 58 angeordnet. Die LEDs 26, 54, 56 können beispielsweise Licht unterschiedlicher Farbe und/oder unterschiedlicher Temperatur emittieren.

Beispielsweise kann die erste LED 26 rotes Licht emittieren, die zweite LED 54 kann grünes Licht emittieren und die dritte LED 56 kann blaues Licht emittieren. Die LEDs 26, 54, 56 emittieren insgesamt beispielsweise weißes Licht, das auch als erstes Licht 40 bezeichnet werden kann und in Figur 8 mittels Pfeilen dargestellt ist. Das erste Licht 40 wird beispielsweise gemäß einer lambert'schen Strahlverteilung abgestrahlt. Das LED-Gehäuse 58 kann beispielsweise ein Kunststoff oder eine Silikongehäuse sein. Die LED 26 und/oder die LEDs 26, 54, 56 in dem LED-Gehäuse 58 können auch als LED-Package bezeichnet werden.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer Flüssiglinse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden. Eine von dem Lichtumlenkelement 34 bewirkte Ablenkung des dritten Lichts 46 wird mittels des optischen Elements 38 verstärkt, so dass ein Winkel zwischen Geraden entlang von Strahlengängen des vierten Lichts 48 und Geraden entlang von Strahlengängen des zweiten Lichts 42 größer ist als zwischen den Geraden entlang der Strahlengänge des dritten Lichts 46 und den Geraden entlang der Strahlengänge des zweiten Lichts 42.

**Fig. 8** zeigt eine schematische Seitenansicht eines Teils eines Ausführungsbeispiels einer lichtemittierenden Baugruppe, beispielsweise der im Vorhergehenden erläuterten lichtemittierenden Baugruppe 20. Insbesondere zeigt Figur 8 einen Teil des Trägers 22, eine der LEDs 26, eine der Linsen 30, eines der Lichtumlenkelemente 34 und eines der optischen Elemente 38. Der Träger 22, die LEDs 26, die Linse 30, das Lichtumlenkelement 34 und das optische Element 38 können beispielsweise wie mit Bezug zu Figur 1 erläutert ausgestaltet sein.

Die LED 26 emittiert erstes Licht 40, das in den Figuren mittels Pfeilen dargestellt ist. Das erste Licht 40 wird beispielsweise gemäß einer Lambert'schen Strahlverteilung abgestrahlt.

Die Linse 30 ist vorzugsweise so ausgebildet und so zu der LED 26 angeordnet, dass ein Großteil des von der LED 26 emittierten Lichts in die Linse 30 eingekoppelt wird. Die Linse 30 formt das erste Licht 40 zu zweitem Licht 42 und strahlt dieses ab. Die Linse 30 kollimiert das von der LED 26 kommende Licht, so dass Strahlengänge des zweiten Lichts 42 im Wesentlichen parallel zueinander sind. Die Linse 30 ist als TIR-Linse ausgebildet.

Das Lichtumlenkelement 34 ist so ausgebildet und angeordnet, dass das von der Linse 30 kommende kollimierte Licht auf das Lichtumlenkelement 34 trifft und von dem Lichtumlenkelement 34 umgelenkt wird. Das von dem Lichtumlenkelement 34 umgelenkte Licht kann auch als drittes Licht 46 bezeichnet werden. Geraden entlang von Strahlengängen des dritten Lichts 46 schließen einen Winkel mit Geraden entlang von Strahlengängen des zweiten Lichts 42 ein. Ein Grad und/oder eine Richtung der Ablenkung des Lichts mittels des Lichtumlenkelements 34 kann abhängig von einer elektrischen Ansteuerung des Lichtumlenkelements 34 verändert werden. Eine aktuelle Einstellung des Lichtumlenkelements 34 und ein dadurch vorgegebener Grad bzw. eine dadurch vorgegebene Richtung der Ablenkung sind in der Figur mittels der gestrichelten geraden Linie dargestellt. Die gestrichelte Linie kann beispielsweise die Grenzfläche zwischen den zwei Flüssigkeiten im Falle einer Flüssiglinse symbolisieren. Dabei ist anzumerken, dass die Grenzfläche in der Realität normalerweise nicht zu einer geraden Linie oder einer flachen Ebene korrespondiert, sondern eher zu einer konkav oder konvex geformten und/oder gestauchten oder gestreckten dreidimensionalen Fläche korrespondiert.

Das optische Element 38 ist so ausgebildet und angeordnet, dass das von dem Lichtumlenkelement 34 kommende Licht auf das optische Element 38 trifft und von diesem abgelenkt wird. Das von dem optischen Element 38 abgelenkte Licht kann auch als viertes Licht 48 bezeichnet werden. Eine von dem Lichtumlenkelement 34 bewirkte Ablenkung des dritten Lichts 46 wird mittels des optischen Elements 38 verstärkt, so dass ein Winkel zwischen Geraden entlang von Strahlengängen des vierten Lichts 48 und Geraden entlang von Strahlengängen des zweiten Lichts 42 größer ist als zwischen den Geraden entlang der Strahlengänge des dritten Lichts 46 und den Geraden entlang der Strahlengänge des zweiten Lichts 42.

Die Erfindung ist nicht auf die angegebenen Ausführungsbeispiele beschränkt. Beispielsweise können die in den Figuren gezeigten Ausführungsbeispiele miteinander kombiniert werden. Beispielsweise kann die in Figur 1 gezeigte lichtemittierende Baugruppe LEDs 26, 54, 56, Linsen 30, Lichtumlenkelemente 34 und/oder optische Elemente 38 aufweisen, wie sie mit Bezug zu einer der Figuren 2 bis 8 erläutert sind, wobei diese Elemente alle aus dem gleichen Ausführungsbeispiel oder aus verschiedenen der gezeigten Ausführungsbeispielen entnommen und miteinander kombiniert werden können. Beispielsweise können alle der gezeigten Ausführungsbeispiele mehrere LEDs 26, 54, 56 aufweisen, die gemeinsam einer der Linsen 30 zugeordnet sind. Ferner kann die lichtemittierende Baugruppe 20 Linsen 30 aufweisen, denen lediglich eine der LEDs 26, 54, 56 zugeordnet ist, und Linsen 30 aufweisen, denen zwei oder mehr der LEDs 26, 54, 56 zugeordnet sind. Ferner können alle der gezeigten Ausführungsbeispiele ausschließlich Linsen 30 aufweisen, die als TIR-Linsen ausgebildet sind. Ferner kann die lichtemittierende Baugruppe 20 Linsen 30 aufweisen, die als TIR-Linsen ausgebildet sind, und Linsen 30 aufweisen, die nicht als TIR-Linsen ausgebildet sind. Ferner können alle der gezeigten Ausführungsbeispiele optische Elemente 38 aufweisen, die jeweils Teilbereiche 50, 52 aufweisen. Ferner kann die lichtemittierende Baugruppe 20 optische Elemente 38 aufweisen, die jeweils Teilbereiche 50, 52 aufweisen, und optische Elemente 38 aufweisen, die keine Teilbereiche 50, 52 aufweisen. Ferner können alle der gezeigten Ausführungsbeispiele Linsen 30 aufweisen, die das erste Licht 40 kollimieren, oder Linsen 30, die das erste Licht fokussieren. Ferner kann die lichtemittierende Baugruppe 20 Linsen 30 aufweisen, die das erste Licht kollimieren, und Linsen 30 aufweisen, die das erste lichte 40 fokussieren.

**BEZUGSZEICHENLISTE**

| | |
|---|---|
| Lichtemittierende Baugruppe | 20 |
| Träger | 22 |
| LED-Anordnung | 24 |
| LED | 26 |
| Linsenanordnung | 28 |
| Linse | 30 |
| Lichtumlenkmodul | 32 |
| Lichtumlenkelemente | 34 |
| funktionalisierte Optik | 36 |
| optisches Element | 38 |
| erstes Licht | 40 |
| zweites Licht | 42 |
| drittes Licht | 46 |
| viertes Licht | 48 |
| erster Teilbereich | 50 |
| zweiter Teilbereich | 52 |
| zweite LED | 54 |
| dritte LED | 56 |
| LED-Gehäuse | 58 |

## Patentansprüche

1. Lichtemittierende Baugruppe (20), mit
- mehreren LEDs (26), die auf einem Träger (22) lateral voneinander beabstandet angeordnet sind,
- mehreren Linsen (30), die in Strahlengängen der LEDs (26) angeordnet sind, die jeweils mindestens einer der LEDs (26) zugeordnet sind und die das Licht der entsprechenden LEDs (26) kollimieren oder fokussieren,
- mehreren Lichtumlenkelementen (34), die so angeordnet sind, dass das mittels der Linsen (30) kollimierte oder fokussierte Licht auf die Lichtumlenkelemente (34) trifft, die jeweils das auf sie treffende Licht umlenken und die so ansteuerbar sind, dass jeweils die Richtung, in die das Licht umgelenkt wird, abhängig von der Ansteuerung veränderbar ist, und
- mehreren optischen Elementen (38), die das mittels der Lichtumlenkelemente (34) umgelenkte Licht umlenken, **dadurch gekennzeichnet, dass** die Lichtumlenkelemente (34) optische Linsen mit elektrisch verstellbarem Fokuspunkt und/oder mit elektrisch verstellbarer Brennweite sind.

2. Lichtemittierende Baugruppe (20) nach Anspruch 1, bei der die Lichtumlenkelemente (34) Fluidikzellen sind.

3. Lichtemittierende Baugruppe (20) nach Anspruch 2, bei der die Lichtumlenkelemente (34) Fluidlinsen sind.

4. Lichtemittierende Baugruppe (20) nach Anspruch 3, bei der bei den Fluidlinsen der Fokuspunkt und/oder die Brennweite mittels Elektrobenetzung verstellbar sind.

5. Lichtemittierende Baugruppe (20) nach einem der vorstehenden Ansprüche, bei der die Lichtumlenkelemente (34) jeweils einer der Linsen (30) zugeordnet sind und das Licht, das von der entsprechenden Linse (30) kollimiert und/oder fokussiert wird, umlenken.

6. Lichtemittierende Baugruppe (20) nach einem der vorstehenden Ansprüche, bei der die Linsen (30) das mittels der LEDs (26) erzeugte Licht kollimieren und bei dem Strahlengänge des mittels verschiedener Linsen (30) kollimierten Lichts parallel zueinander sind.

7. Lichtemittierende Baugruppe (20) nach einem der vorstehenden Ansprüche, bei der jeder Linse (30) zwei oder mehr der LEDs (26) zugeordnet sind und die Linsen (30) das Licht der entsprechenden LEDs (26) kollimieren und/oder fokussieren.

8. Lichtemittierende Baugruppe (20) nach einem der vorstehenden Ansprüche, bei der die Linsen (30) TIR-Linsen sind.

9. Lichtemittierende Baugruppe (20) nach einem der vorstehenden Ansprüche, bei der eines, zwei oder mehr der optischen Elemente (38) so ausgebildet sind, dass Licht, das in einer vorgegebenen Richtung auf einen Teilbereich (50) des entsprechenden optischen Elements (38) gelenkt wird, in eine andere Richtung umgelenkt wird, als Licht, das in der vorgegebenen Richtung auf einen anderen Teilbereich (52) des entsprechenden optischen Elements (38) gelenkt wird.

10. Lichtemittierende Baugruppe (20) nach einem der vorstehenden Ansprüche, bei der den optischen Elementen (38) jeweils eines der Lichtumlenkelemente (34) zugeordnet ist und die optischen Elemente (38) das von dem entsprechenden Lichtumlenkelement (34) umgelenkte Licht umlenken.

11. Lichtemittierende Baugruppe (20) nach einem der vorstehenden Ansprüche, bei der die optischen Elemente (38) diffraktive Elemente und/oder refraktive Elemente aufweisen.

12. Lichtemittierende Baugruppe (20) nach einem der vorstehenden Ansprüche, bei der die LEDs (26) jeweils in LED-Gehäusen (58) angeordnet sind, die auf dem Träger (22) angeordnet sind.

13. Lichtemittierende Baugruppe (20) nach Anspruch 12, bei der alle LEDs (26, 54, 56), die derselben Linse (30) zugeordnet sind, in demselben LED-Gehäuse (58) angeordnet sind.

14. 10. Verfahren zum Betreiben einer lichtemittierenden Baugruppe (20), bei dem
mehrere LEDs (26) der lichtemittierenden Baugruppe (20) so angesteuert werden, dass sie Licht emittieren, welches von mehreren den LEDs zugeordneten Linsen (30) in Strahlengängen der LEDs (26) kollimiert oder fokussiert wird und auf mehrere Lichtumlenkelemente (34) gerichtet wird, und
die Lichtumlenkelemente (34), die jeweils das auf sie treffende Licht umlenken, so angesteuert werden, dass die jeweilige Richtung, in die das Licht von ihnen umgelenkt wird, abhängig von der Ansteuerung veränderbar ist, und dass das Licht abhängig von der Ansteuerung auf verschiedene Teilbereiche mehrerer optischer Elemente (38) gerichtet wird, die das mittels der Lichtumlenkelemente (34) umgelenkte Licht umlenken, **dadurch gekennzeichnet, dass** die Lichtumlenkelemente (34) optische Linsen mit elektrisch verstellbarem Fokuspunkt und/oder mit elektrisch verstellbarer Brennweite sind.

## Claims

1. A light emitting assembly (20), with
- several LEDs (26) arranged on a carrier (22) laterally spaced from each other,
- a plurality of lenses (30) arranged in beam paths of the LEDs (26), each of which is associated with at least one of the LEDs (26) and which collimate or focus the light of the corresponding LEDs (26),
- a plurality of light-deflecting elements (34) which are arranged in such a way that the light collimated or focused by means of the lenses (30) impinges on the light-deflecting elements (34), which each deflect the light impinging on them and which can be driven in such a way that the direction in which the light is deflected can be changed as a function of the drive, and
- a plurality of optical elements (38) which deflect the light deflected by means of the light deflecting elements (34), **characterized in that** the light deflecting elements (34) are optical lenses with an electrically adjustable focal point and/or with an electrically adjustable focal length.

2. The light-emitting assembly (20) according to claim 1, in which the light deflecting elements (34) are fluidic cells.

3. The light-emitting assembly (20) according to claim 2, in which the light deflecting elements (34) are fluidic lenses.

4. The light-emitting assembly (20) according to claim 3, in which the focal point and/or the focal length of the fluid lenses are adjustable by means of electro-wetting.

5. The light-emitting assembly (20) according to one of the above claims, in which the light deflecting elements (34) are each associated with one of the lenses (30) and deflect the light collimated and/or focused by the corresponding lens (30).

6. The light-emitting assembly (20) according to one of the above claims, in which the lenses (30) collimate the light produced by means of the LEDs (26) and in which the beam paths of the light collimated by means of different lenses (30) are parallel to one another.

7. The light-emitting assembly (20) according to one of the above claims, in which two or more of the LEDs (26) are associated with each lens (30) and the lenses (30) collimate and/or focus the light of the corresponding LEDs (26).

8. The light emitting assembly (20) according to any of the foregoing claims, wherein the lenses (30) are TIR lenses.

9. The light emitting assembly (20) according to any one of the above claims, wherein one, two or more of the optical elements (38) are formed such that light directed in a predetermined direction to one portion (50) of the corresponding optical element (38) is deflected in a direction different from light directed in the predetermined direction to another portion (52) of the corresponding optical element (38).

10. The light emitting assembly (20) according to any of the above claims, wherein the optical elements (38) are each associated with one of the light deflecting elements (34) and the optical elements (38) deflect the light deflected by the corresponding light deflecting element (34).

11. The light-emitting assembly (20) according to one of the above claims, in which the optical elements (38) have diffractive elements and/or refractive elements.

12. The light-emitting assembly (20) according to one of the above claims, in which the LEDs (26) are each arranged in LED housings (58) which are arranged on the carrier (22).

13. The light-emitting assembly (20) according to claim 12, in which all LEDs (26, 54, 56) associated with the same lens (30) are arranged in the same LED housing (58).

14. A method of operating a light emitting assembly (20), wherein
a plurality of LEDs (26) of the light-emitting assembly (20) are driven so that they emit light which is collimated or focused by a plurality of lenses (30) associated with the LEDs in beam paths of the LEDs (26) and is directed onto a plurality of light deflecting elements (34), and
the light deflecting elements (34), which each deflect the light incident thereon, are controlled in such a way that the respective direction in which the light is deflected by them can be changed as a function of the control, and that the light is directed, as a function of the control, onto different subregions of a plurality of optical elements (38) which deflect the light deflected by means of the light deflecting elements (34), **characterized in that** the light deflecting elements (34) are optical lenses with an electrically adjustable focal point and/or with an electrically adjustable focal length.

## Revendications

1. Sous-ensemble émetteur de lumière (20) avec
- plusieurs LED (26) qui sont disposées sur un support (22) de manière distante latéralement entre elles,
- plusieurs lentilles (30) qui sont disposées dans les trajets des faisceaux des LED (26), qui correspondent chacune à au moins une des LED (26) et qui collimatent ou focalisent la lumière des LED (26) correspondantes,
- plusieurs éléments de déviation de lumière (34), qui sont disposés de façon à ce que la lumière collimatée ou focalisée au moyen des lentilles (30) arrive sur les éléments de déviation de lumière (34) qui dévient chacun la lumière qui arrive sur eux et qui peuvent être contrôlés de façon à ce que la direction dans laquelle la lumière est déviée puisse être modifiée en fonction du contrôle et
- plusieurs éléments optiques (38) qui dévient la lumière déviée au moyen des éléments de déviation de lumière (34), **caractérisé en ce que** les éléments de déviation de lumière (34) sont des lentilles optiques avec un point focal réglable électriquement et/ou avec une focale réglable électriquement.

2. Sous-ensemble émetteur de lumière (20) selon la revendication 1, dans lequel les éléments de déviation de lumière (34) sont des cellules fluidiques.

3. Sous-ensemble émetteur de lumière (20) selon la revendication 2, dans lequel les éléments de déviation de lumière (34) sont des lentilles fluides.

4. Sous-ensemble émetteur de lumière (20) selon la revendication 3, dans lequel, dans les lentilles fluides, le point focal et/ou la focale sont réglables au moyen d'un électromouillage.

5. Sous-ensemble émetteur de lumière (20) selon l'une des revendications précédentes, dans lequel les éléments de déviation de lumière (34) correspondent chacun à une des lentilles (30) et dévient la lumière qui est collimatée et/ou focalisée par la lentille (30) correspondante.

6. Sous-ensemble émetteur de lumière (20) selon l'une des revendications précédentes, dans lequel les lentilles (30) collimatent la lumière produite au moyen des LED (26) et dans lequel les trajets des faisceaux de la lumière collimatée au moyen des différentes lentilles (30) sont parallèles entre eux.

7. Sous-ensemble émetteur de lumière (20) selon l'une des revendications précédentes, dans lequel, à chaque lentille (30), correspondent deux LED (26) ou plus et les lentilles (30) collimatent et/ou focalisent la lumière des LED (26) correspondantes.

8. Sous-ensemble émetteur de lumière (20) selon l'une des revendications précédentes, dans lequel les lentilles (30) sont des lentilles TIR.

9. Sous-ensemble émetteur de lumière (20) selon l'une des revendications précédentes, dans lequel un, deux ou plus des éléments optiques (38) sont conçus de façon à ce que la lumière qui est déviée dans une direction prédéterminée vers une zone (50) de l'élément optique (38) correspondant est déviée dans une direction différente de la lumière qui est déviée dans la direction prédéterminée vers une autre zone (52) de l'élément optique (38) correspondant.

10. Sous-ensemble émetteur de lumière (20) selon l'une des revendications précédentes, dans lequel, à chacun des éléments optiques (38) correspond un des éléments de déviation de lumière (34) et les éléments optiques (38) dévient la lumière déviée par l'élément de déviation de lumière (34) correspondant.

11. Sous-ensemble émetteur de lumière (20) selon l'une des revendications précédentes, dans lequel les éléments optiques (38) comprennent des éléments diffracteurs et/ou réfracteurs.

12. Sous-ensemble émetteur de lumière (20) selon l'une des revendications précédentes, dans lequel les LED (26) sont disposées chacune dans les boîtiers de LED (58) qui sont disposés sur le support (22).

13. Sous-ensemble émetteur de lumière (20) selon la revendication 12, dans lequel toutes les LED (26, 54, 56) qui correspondent à la même lentille (30) sont disposées dans le même boîtier de LED (58).

14. Procédé de fonctionnement d'un sous-ensemble émetteur de lumière (20), dans lequel
plusieurs LED (26) du sous-ensemble émetteur de lumière (20) est contrôlé de façon à émettre de la lumière qui est collimatée ou focalisée par plusieurs des lentilles (30) correspondant aux LED dans des trajets de faisceaux des LED (26) et qui est dirigée vers plusieurs éléments de déviation de lumière (34),
les éléments de déviation de lumière (34), qui dévient chacun la lumière qui arrive sur eux, sont contrôlés de façon à ce que la direction dans laquelle la lumière est déviée par eux peut être modifiée par le contrôle et de façon à ce que la lumière soit dirigée, en fonction du contrôle, vers des zones différentes de plusieurs éléments optiques (38), qui dévient la lumière déviée au moyen des éléments de déviation de lumière (34), **caractérisé en ce que** les éléments de déviation de lumière (34) sont des lentilles optiques avec un point focal réglable électriquement et/ou avec une focale réglable électriquement.
